# EUROPEAN PATENT SPECIFICATION

(11) **EP 1 372 195 B1**
(45) Date of publication and mention of the grant of the patent: **14.12.2011**
(21) Application number: 03077454.1
(22) Date of filing: 02.09.1998
(51) Int. Cl.: H01L 27/00

(54) **Manufacturing process for an organic electroluminescent element**
Verfahren zur Herstellung eines organischen elektrolumineszenten Elements
Procédé de fabrication d'un élément électroluminescent organique

(30) Priority: 02.09.1997 JP 23710397; 29.07.1998 JP 21459698
(43) Date of publication of application: 17.12.2003
(62) Divisional of application: 98941685.4
(73) Proprietor: Seiko Epson Corporation, Shinjuku-ku Tokyo 163-0811 (JP)
(72) Inventor: Seki, Sunichi, Suwa-shi, Nagano-ken 392-8502 (JP); Kiguchi, Hiroshi, Suwa-shi, Nagano-ken 392-8502 (JP)
(74) Representative: Sturt, Clifford Mark

(56) References cited:
- EP-A- 0 736 913
- WO-A-99/12398
- CAO Y ET AL: "Polymer light-emitting diodes with polyethylene dioxythiophene-polystyrene sulfonate as the transparent anode" SYNTHETIC METALS, ELSEVIER SEQUOIA, LAUSANNE, CH, vol. 87, 31 March 1997 (1997-03-31), pages 171-174, XP002127849 ISSN: 0379-6779
- CARTER S A ET AL: "Polymeric anodes for improved polymer light-emitting diode performance" APPLIED PHYSICS LETTERS, AMERICAN INSTITUTE OF PHYSICS. NEW YORK, US, vol. 70, no. 16, 21 April 1997 (1997-04-21), pages 2067-2069, XP002110222 ISSN: 0003-6951

## Description

### TECHNICAL FIELD

The present invention relates to a manufacturing process for an organic EL (electroluminscence) element, an electrically light-emitting element that may be used in displays, display light sources, and the like. In particular, it relates to a composition for use as a hole injecting and transporting layer suitable for ink jet patterning.

### BACKGROUND ART

When electric charge is applied to a solid thin film containing a fluorescent organic molecule and sandwiched between electrodes, holes (holes) are injected from the anode and electrons from the cathode, these carriers moving through the thin film due to the applied electric field, and recombining. An element in which the energy released during this recombination is consumed in the formation of a singlet excitation state of the fluorescent molecule (molecule exciton), and the fluorescence emitted with relaxation of the singlet exciton to ground state is utilized is an organic EL element.

Apropos, with a single-layer type structure element comprising a light-emitting layer only, light emission efficiency is low and there are problems with durability, and therefore a two-layer type structure element provided with a hole injecting and transporting layer with good contact situated between the anode and the light-emitting layer has been proposed. Through the use of a stacked structure to control carrier injection/transport balance and carrier recombination location, EL light-emitting element light emission efficiency and durability can be improved. Further, according to a stacked structure, the functions of light emission and injection/transport can be carried out by separate materials, which provides the advantage of making possible optimal design of materials and elements.

In the past, as hole injecting and transporting layer compounds for two-layer stacked type organic EL elements, there have been proposed in the past a porphyrinic compound (US Patents 4,356,429 and 4,720,432), aniline, pyridine, and low-molecular weight derivatives thereof (Unexamined Patent Application (Kokai) 3-34382), hole injecting and transporting layers using carbon layers (Unexamined Patent Application (Kokai) 8-31573), etc. The formation of hole injecting and transporting layers using these low-molecular weight materials is usually accomplished by film formation methods involving vacuum deposition or sputtering. Polyaniline (Nature, 357, 477 (1992), etc. are known as low-molecular weight materials, film formation being carried out by a wet proceed such as spin coating, etc.

However, film formation methods involving vacuum deposition or sputtering are batch processes having extended time periods, and thus mass production efficiency is poor. In the case of low-molecular weight materials, there are the problems of susceptibility to crystallization after film formation and lower element reliability. On the other hand, in the case of high-molecular weight materials, there are the advantages of a high degree of freedom in molecular design, and ease of optimization of materials owing to a wet process; however, film formation methods such as spin coating, etc., have a big problem in that virtually all of the material is wasted.

In cases where fine patterning of materials is required, as in full-color displays, etc., there are the fundamental problems that high-precision patterning is difficult in deposition processes, while the materials lack durability against patterning processes involving photolithography. The same problems exist in the case of high-molecular weight materials as well. The materials used as hole injecting and transporting layers or buffer layers are conductive, and thus if complete patterning cannot be realized, this can result in leakage current between adjacent pixels located on a given substrate.

### DISCLOSURE OF THE INVENTION

According to the present invention there is provided a process of manufacturing an organic EL element including a hole injecting and transporting layer and a light-emitting layer, the method comprising:
forming a partitioning member having openings corresponding to pixel areas on a substrate; and
forming the hole injecting and transporting layer by using an ink-jet type recording head to eject a composition including a conductive compound into the openings, the composition having a viscosity in the range 1 cps to 20 cps at a temperature of 20°C.

### (1) Contact angle

In preferred practice, the contact angle of the composition for a hole injecting and transporting layer and the material making up the nozzle face of the ink-jet type recording head will be established within the range 30 °-170 ° . Establishment within the range 35 °-65 ° is especially preferred.

By means of the composition for a hole injecting and transporting layer having a contact angle of this range, bending of flight during discharge can be reduced, making possible precise discharge control. Where the contact angle is smaller than 30 °, wetting of the composition for a hole injecting and transporting layer at the nozzle face increases, so that when the composition for a hole injecting and transporting layer is discharged, the composition for a hole injecting and transporting layer sometimes adheres asymmetrically about the perimeter of the nozzle hole. In this case, mutual attraction between the composition for a hole injecting and transporting layer adhering to the nozzle and the composition for a hole injecting and transporting layer which is being discharged acts in such a way that the composition for a hole injecting and transporting layer is discharged through uneven force, so that bending of flight occurs and the target location cannot be impacted. Further, the frequency of bending of flight increases. On the other hand, where the contact angle exceeds 170 °, interaction between the composition for a hole injecting and transporting layer and the nozzle hole is at a minimum, and the shape of the meniscus at the nozzle distal end is not stable, with the result that the composition for a hole injecting and transporting layer discharge amount and discharge timing are difficult to control.

Bending of flight refers to misplacement of the impact location of the composition for a hole injecting and transporting layer by 30 µm or more away from the target location when the composition for a hole injecting and transporting layer is discharged from the nozzle hole. Frequency of bending of flight refers to the time elapsed until bending of flight occurs during continuous discharge at an ink-jet type recording head piezoelectric thin film element oscillation frequency of 14.4 kHz, for example.

### (2) Viscosity

The viscosity of the composition for a hole injecting and transporting layer will be in the range 1 cps-20 cps. Establishment within the range 2 cps-4 cps is especially preferred.

Where the viscosity of the composition for a hole injecting and transporting layer is below 1 cps, the meniscus of the composition for a hole injecting and transporting layer at the nozzle hole will not be stable, making discharge control difficult. On the other hand, where the viscosity exceeds 20 cps, it will not be possible to smoothly discharge the composition for a hole injecting and transporting layer from the nozzle hole, making ink discharge difficult unless the specifications of the ink-jet type recording head are modified, such as by making the nozzle hole bigger, etc. Where viscosity is high, the solid ingredients in the composition for a hole injecting and transporting layer will tend to precipitate, increasing the frequency of nozzle hole clogging.

### (3) Surface tension

In preferred practice, the surface tension of the composition for a hole injecting and transporting layer will be established in the range 20 dyne/cm-70 dyne/cm. Establishment within the range 25 dyne/cm-40 dyne/cm is especially preferred.

By establishing the surface tension within this range, bending of flight is reduced analogously to the contact angle described earlier, and the frequency of bending of flight can be reduced. Where surface tension is greater than 70 dyne/cm, the shape of the meniscus at the nozzle distal end is not stable, with the result that the composition for a hole injecting and transporting layer discharge amount and discharge timing are difficult to control. On the other hand, where surface tension is lower than 20 dyne/cm, wetting of the composition for a hole injecting and transporting layer with respect to the material of the nozzle face increases, so that, as with the contact angle described earlier, bending of flight occurs and the frequency of bending of flight becomes high.

This bending of flight occurs mainly when there is uneven wetting of the nozzle hole, when there is clogging due to adhesion of solid matter in the composition for a hole injecting and transporting layer, etc., and can be solved through cleaning of the ink-jet type recording head (hereinafter termed "flushing"). Flushing usually involves working the ink-jet type recording head mechanism so as to prevent clogging and bending of flight, the design being such that a prescribed amount of the composition for a hole injecting and transporting layer is forcedly discharged when discharge of the composition for a hole injecting and transporting layer has not been carried out for a given time (hereinafter termed "flushing time"). This flushing time refers to the time required for a nozzle to dry and give rise to bending of flight when not discharging the composition for a hole injecting and transporting layer, and is indicative of the properties of the composition for a hole injecting and transporting layer. The longer the flushing time, the more appropriate [the composition is] for ink-jet printing techniques, thus allowing the composition for a hole injecting and transporting layer to be discharged in a stable manner for extended periods.

Accordingly, by endowing the composition for a hole injecting and transporting layer with the physical properties mentioned earlier, it is possible to produce a longer flushing time and to maintain a more fresh state at the interface of the composition for a hole injecting and transporting layer with the air. It is additionally possible to produce uniform dot density of the composition for a hole injecting and transporting layer being discharged, thereby making it possible to prevent the occurrence of irregularities, etc., of the composition for a hole injecting and transporting layer. Further, since the linearity of flight is excellent, control of the ink-jet type recording head is facilitated, and a simple constitution may be adopted for the manufacturing equipment.

In preferred practice, a mixed solution of water and a lower alcohol (e.g., methanol, ethanol, etc.) will be used as the polar solvent. A mixed solution of water and a Cellosolve solvent (e.g., ethoxy ethanol, etc.) can also be used. In preferred practice, the lubricant will be glycerin. The manufacturing process for a composition for a hole injecting and transporting layer which pertains to the present invention may entail preparation via a sonication process and a filtration process.

The manufacturing process for an organic EL element which pertains to the present invention is a manufacturing process for an organic EL element having a stacked structure of a hole injecting and transporting layer and a light-emitting layer formed within a partitioning member divided into individual pixel areas, comprising a step wherein a partitioning member provided with openings corresponding to pixel areas is formed on a substrate; a step wherein an ink-jet type recording head is used to fill the aforementioned openings with the composition for a hole injecting and transporting layer which pertains to the present invention; and a step wherein the composition for a hole injecting and transporting layer that has filled the openings is subjected to a drying process to form a hole injecting and transporting layer. Through this method, hole injecting and transporting layer film thickness, dot count, and other parameters may be controlled in a desired manner, allowing the size and pattern of the organic EL element to be established in a desired manner as well.

The organic EL element which pertains to the present invention is manufactured through the foregoing process, and the film thickness of the hole injecting and transporting layer is 0.1 µm or less. The film resistance of the hole injecting and transporting layer is in the range 0.5 × 10⁹ Ω/m² to 5 × 10⁹ Ω/m². By establishing the film thickness and the film resistance of the hole injecting and transporting layer within the preceding ranges, the light-emission characteristics of the organic EL element can be improved.

### BRIEF DESCRIPTION OF THE DRAWINGS

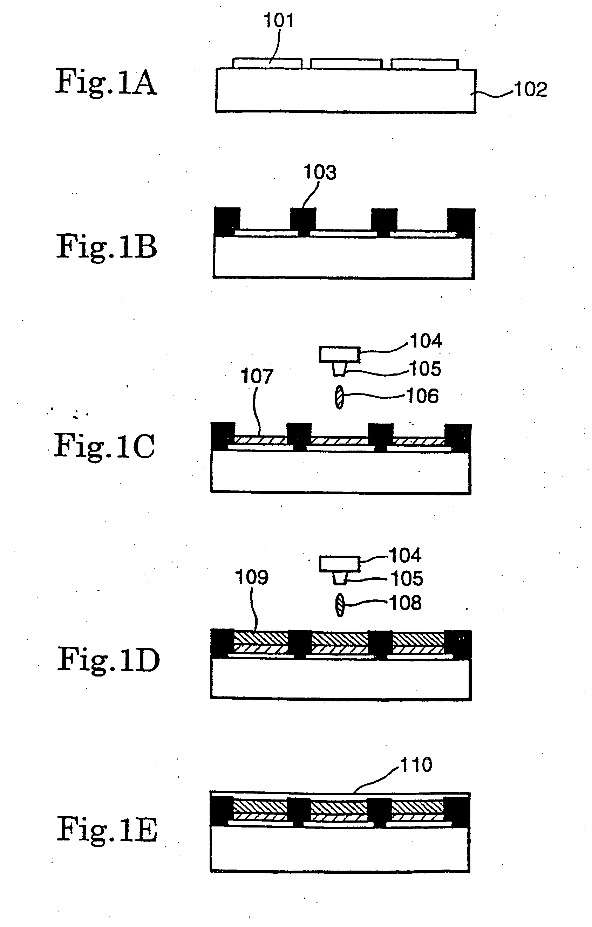

Fig. 1 is a sectional view of manufacturing steps for an organic EL element.

### BEST MODE FOR CARRYING OUT THE INVENTION

### Embodiment of Invention 1.

A composition for a hole injecting and transporting layer, organic EL element manufacturing process, and organic EL element pertaining to an aspect of the present embodiment is described below.

The composition for a hole injecting and transporting layer principally contains a conductive compound for forming the hole injecting and transporting layer, a dispersant solvent, and a lubricant, and is used for pattern film formation through an ink-jet system. In preferred practice, the conductive compound for forming the hole injecting and transporting layer is a compound having lower ionization potential than the anode. For example, where ITO is used for the anode, examples of low-molecular weight materials would include copper phthalocyanine and other porphyrinic compounds.

Other additives, as well as film stabilizing materials, may be added as well; for example, viscosity modifiers, antioxidants, pH modifiers, preservatives, resin emulsions, leveling agents, etc., may be used.

### (Example)

Using copper phthalocyanine as the conductive compound (hole injecting and transporting layer component), the physical characteristics of compositions for a hole injecting and transporting layer [produced therefrom] were studied. Composition 1 through Composition 10, given in Table 1 through Table 10, were prepared as specimens.

**Table 1**

| Composition 1 | | |
|---|---|---|
| | Ingredient | Content (wt%) |
| Hole injecting and transporting layer Component | copper phthalocyanine (10 wt%) (styrene acrylic resin dispersion) | 25 |
| Polar solvent | water | 70 |
| Lubricant | glycerin | 5 |

**Table 2**

| composition 2 | | |
|---|---|---|
| | Ingredient | Content (wt%) |
| Hole injecting and transporting layer component | copper phthalocyanine (10 wt%)(styrene acrylic resin dispersion) | 25 |
| Polar solvent | water | 65 |
| | methanol | 5 |
| Lubricant | glycerin | 5 |

**Table 3**

| Composition 3 | | |
|---|---|---|
| | Ingredient | Content (wt%) |
| Hole injecting and transporting layer Component | copper phthalocyanine (10 wt%) (styrene acrylic resin dispersion) | 25 |
| Polar solvent | water | 65 |
| | ethoxy ethanol | 5 |
| Lubricant | glycerin | 5 |

**Table 4**

| Composition 4 | | |
|---|---|---|
| | Ingredient | Content (wt%) |
| Hole injecting and transporting layer Component | copper phthalocyanine (10 wt%) (styrene acrylic resin dispersion) | 25 |
| Polar solvent | methanol | 70 |
| Lubricant | glycerin | 5 |

**Table 5**

| Composition 5 | | |
|---|---|---|
| | Ingredient | Content (wt%) |
| Hole injecting and transporting layer Component | copper phthalocyanine (10 wt%) (styrene acrylic resin dispersion) | 25 |
| Polar solvent | N, N-methyl formamide | 70 |
| Lubricant | glycerin | 5 |

**Table 6**

| Composition 6 | | |
|---|---|---|
| | Ingredient | Content (wt%) |
| Hole injecting and transporting layer Component | copper phthalocyanine (10 wt%) (styrene acrylic resin dispersion) | 25 |
| Polar solvent | water | 70 |
| Lubricant | -- | 0 |

**Table 7**

| Composition 7 | | |
|---|---|---|
| | Ingredient | Content (wt%) |
| Hole injecting and transporting layer Component | copper phthalocyanine (10 wt%) (styrene acrylic resin dispersion) | 25 |
| Polar solvent | water | 70 |
| | methanol | 5 |
| Lubricant | -- | 0 |

**Table 8**

| Composition 8 | | |
|---|---|---|
| | Ingredient | Content (wt%) |
| Hole injecting and transporting layer Component | copper phthalocyanine (10 wt%) (styrene acrylic resin dispersion) | 25 |
| Polar solvent | water | 70 |
| | ethoxy ethanol | 5 |
| Lubricant | -- | 0 |

**Table 9**

| Composition 9 | | |
|---|---|---|
| | Ingredient | Content (wt%) |
| Hole injecting and transporting layer Component | copper phthalocyanine (10 wt%) (styrene acrylic resin dispersion) | 25 |
| Polar solvent | water | 65 |
| | butoxy ethanol | 5 |
| Lubricant | glycerin | 5 |

**Table 10**

| Composition 10 | | |
|---|---|---|
| | Ingredient | Content (wt%) |
| Hole injecting and transporting layer Component | copper phthalocyanine (10 wt%) (styrene acrylic resin dispersion) | 25 |
| Polar solvent | water | 65 |
| | isopropyl alcohol | 5 |
| Lubricant | glycerin | 5 |

### (Discharge Evaluation)

Composition 1 through Composition 8, given in Table 1 through Table 8, were measured for contact angle with respect to the nozzle face constituent material constituting the ink-jet type recording head, viscosity, and surface tension, and the discharge properties thereof were evaluated. The discharge evaluation was conducted using an ink-jet printing device (Epson MJ-500C).

Viscosity [is expressed as] measured values at 20°C. These results are given in Table 11.

**Table 11**

| Composition | Contact angle [°] | Viscosity [cps] | Surface tension [dyne/cm] | Discharge properties |
|---|---|---|---|---|
| 1 | 135 | 3.8 | 62.8 | ○ |
| 2 | 91 | 3.6 | 40.8 | ○ |
| 3 | 62 | 3.1 | 39.8 | ⊚ |
| 4 | 22 | 0.8 | 23.1 | X |
| 5 | 175 | 0.9 | 81.0 | X |
| 6 | 118 | 1.1 | 71.0 | X |
| 7 | 28 | 0.8 | 68.8 | X |
| 8 | 27 | 0.9 | 69.2 | X |

From these results, it will be apparent that a contact angle of 30° to 170°, and especially 35° to 65°, is preferred. In the present invention, the viscosity is 1 cps to 20 cps, and 2 cps to 4 cps is preferred, and surface tension of 20 dyne/cm to 70 dyne/cm, and especially the range 25 dyne/cm to 40 dyne/cm, is preferred.

Composition 1 through Composition 3, which contain glycerin as a lubricant, when compared to Composition 6 through Composition 8, which do not contain a lubricant, may be seen to be superior in terms of discharge properties. Accordingly, in preferred practice, the ink composition will contain a lubricant. The inclusion of a lubricant can effectively prevent drying and solidification of the ink composition in the nozzle mouth. Examples of the lubricant are glycerin, diethylene glycol, and other polyhydric alcohols; glycerin is especially preferred.

### (Manufacturing process for composition for a hole injecting and transporting layer)

Composition 1 through Composition 3, Composition 9, and Composition 10 given in Table 1 through Table 3, Table 9, and Table 10, respectively, were manufactured, and the particle size distribution of the hole injecting and transporting layer-forming compound (copper phthalocyanine) was measured before and after a sonication. Using the preceding compositions for a hole injecting and transporting layer having been passed through a filtration step subsequent to the sonication , the film forming properties of hole injecting and transporting layers formed through ink-jet system patterning were evaluated.

These results are given in Table 12. Sonication results are expressed as the proportion of the particle size distribution of 1 µm or smaller.

Particle size in the styrene acrylic resin dispersion was 1 µm or above.

**Table 12**

| Composition | 1 µm particle size proportion (%) | | Film forming properties |
|---|---|---|---|
| | before sonication | after sonication | |
| 1 | 4.8 | 46.8 | ○ |
| 2 | 2.8 | 31.4 | ○ |
| 3 | 4.2 | 43.5 | ⊚ |
| 9 | 2.5 | 18.5 | X |
| 10 | 3.9 | 18.2 | X |

From the preceding results, it will be apparent that 4-hour sonication of the dispersion can increase dispersion. Further, by additionally filtering the sonicated dispersion, it is possible to achieve a more homogeneous hole injecting and transporting layer film. As the dispersant polar solvent for the conductive compound, water or a mixed solvent of water and methanol or ethoxy ethanol is preferred (Composition 1 through Composition 3); it will be apparent that, where these solvents are used, film forming properties are good.

### (Organic EL element manufacturing steps)

Using Composition 1 through Composition 3 given in Table 1 through Table 3, patterning film formation of hole injecting and transporting layers by an ink-jet system was carried out by the following procedure to manufacture organic EL elements.

### Anode formation step (Fig. 1A)

The present step is a step for forming an anode 101 on a glass substrate 102. In preferred practice, glass substrate 102 will be one that resists attack by chemicals such as acids, alkalis, etc., and that is mass-producible. An ITO transparent electrode was formed to a thickness of 0.1 µm on substrate 102 and patterned at 100 µm pitch.

### Partitioning member formation step (Fig. 1B)

The present step is a step for forming a partitioning member 103 on glass substrate 102. Specifically, non-photosensitive polyimide (partitioning member) buried between anodes (ITO electrodes) and also serving as an ink drip prevention wall (bank) was formed by photolithography. The non-photosensitive polyimide was 20 µm wide and 2.0 µm thick.

### Composition for a hole injecting and transporting layer discharge step (Fig. 1C)

Hole injecting and transporting layer Compositions 1 through 3 (106 in the drawing) were discharged from the head 105 of an ink-jet printing device (Epson MJ-800C) 104 to effect patterning film formation of a hole injecting and transporting layer 107. After patterning film formation, a hole injecting and transporting layer was formed through a drying treatment (200°C, 10 min). During discharge of the composition for a hole injecting and transporting layer, no bank-overflowing application was observed, and a high-precision hole injecting and transporting layer pattern was achieved.

### Light-emitting layer composition filling step (Fig. 1D)

Next, a PPV precursor (poly(para-phenylene vinylene)) composition was manufactured as a green light-emitting layer. A light-emitting layer composition 108 was discharged by an ink-jet system to effect patterning film formation of a light-emitting layer 109. Rhodamine B-doped PPV, which exhibits red light emission, or coumarin-doped PPV, which exhibits blue light emission, could be used for the light-emitting layer 109 as well. Light-emitting layers exhibiting light emission of the three primary colors (red, green, blue) can be subjected to patterning over a hole injecting and transporting layer to produce a highly detailed full-color organic EL display.

### Cathode formation step (Fig. 1E)

Finally, a cathode 100 was deposited so as to cover the light-emitting layer 109, forming an organic EL element.

### (Hole injecting and transporting layer film formation evaluation)

In the organic EL element manufacturing steps described above, the number of discharges of the composition for a hole injecting and transporting layer was varied, and the hole injecting and transporting layer film thickness and sheet resistance were measured, as well as evaluating film formation. Results are given in Table 13.

**Table 13**

| Composition | Discharge no. | Film thickness [µm] | Resistance [Ω/m²] | Film-forming properties | Luminance [cd/m²] |
|---|---|---|---|---|---|
| 1 | 1 | 0.05 | 5.0 × 10⁹ | ○ | 2000 |
| | 3 | 0.14 | 1.7 × 10⁹ | ○ | 1900 |
| | 5 | 0.26 | 0.9 × 10⁹ | X | 1600 |
| 2 | 1 | 0.03 | 0.7 × 10⁹ | ⊚ | 2000 |
| | 3 | 0.1 | 0.2 × 10⁹ | X | 1500 |
| | 5 | 0.14 | 0.1 × 10⁹ | X | 1500 |
| 3 | 1 | 0.02 | 0.5 × 10⁹ | ⊚ | 2000 |
| | 3 | 0.06 | 0.2 × 10⁹ | ○ | 1800 |
| | 5 | 0.1 | 0.1 × 10⁹ | X | 1400 |

From these results, it will be apparent that in the case of a low-molecular weight material, where the hole injecting and transporting layer film thickness is 0.05 µm or smaller and film resistance is from 0.5 × 10⁹ Ω/m² to 5 × 10⁹ Ω/m², light-emission characteristics are good.

### (Effect)

According to the present aspect of the embodiment, fine patterning can be realized easily, in a short time, and at low cost. Accordingly, there is no risk of leakage due to the hole injecting and transporting layer itself, a problem that could not be solved in solid film formation methods. Further, since film thickness can be readily controlled through manipulation of the discharge amount or number of discharges, optimization of thin film design thereby is possible.

### Aspect of Embodiment of the Invention 2.

The present aspect of embodiment is one in which the conductive compound for forming the hole injecting and transporting layer is a material capable of forming a film from solution (high-molecular weight material), and is one that employs polyaniline, polysilane, or other conductive high-molecular weight material. In particular, as water can be used as the principal solvent, and as characteristics can be adjusted through the mixture ratio, a mixed material of PEDT (polyethylene dioxythiophene) 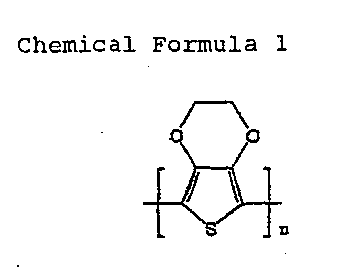 and PSS (polystyrene sulfonic acid) 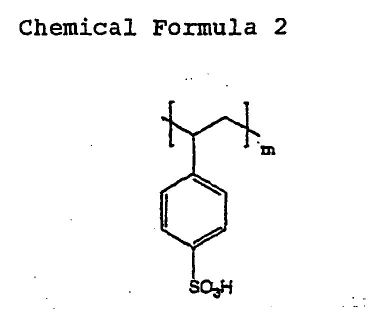 is preferred.

### (Example)

Compositions for a hole injecting and transporting layer prepared using a PEDT/PSS mixture aqueous solution as the high-molecular weight material (hole injecting and transporting layer component) were prepared in the five varieties (Composition 11 through Composition 15) given in Table 14 through Table 18.

**Table 14**

| Composition 11 | | |
|---|---|---|
| Composition | Material name | Content (wt%) |
| Hole injecting and transporting layer component | PEDT/PSS mixture aqueous dispersion(1.0 wt%) | 20 |
| Polar solvent | water | 80 |
| Lubricant | -- | 0 |

**Table 15**

| Composition 12 | | |
|---|---|---|
| Composition | Material name | Content (wt%) |
| Hole injecting and transporting layer component | PEDT/PSS mixture aqueous dispersion(1.0 wt%) | 20 |
| Polar solvent | N,N-dimethyl formamide | 75 |
| Lubricant | glycerin | 5 |

**Table 16**

| Composition 13 | | |
|---|---|---|
| Composition | Material name | Content (wt%) |
| Hole injecting and transporting layer component | PEDT/PSS mixture aqueous dispersion(1.0 wt%) | 20 |
| Polar solvent | water | 75 |
| Lubricant | glycerin | 55 |

**Table 17**

| Composition 14 | | |
|---|---|---|
| Composition. | Material name | Content (wt%) |
| Hole injecting and transporting layer component | PEDT/PSS mixture aqueous dispersion(1.0 wt%) | 20 |
| Polar solvent | water | 70 |
| | methanol | 5 |
| Lubricant | glycerin | 5 |

**Table 18**

| Composition 15 | | |
|---|---|---|
| Composition | Material name | Content (wt%) |
| Hole injecting and transporting layer component | PEDT/PSS mixture aqueous dispersion(1.0 wt%) | 20 |
| Polar solvent | water | 65 |
| | ethoxy ethanol | 10 |
| Lubricant | glycerin | 5 |

Discharge evaluations were conducted using an ink-jet printing device (Epson MJ-800C). Film-forming properties evaluations were conducted in film state after a heating treatment (200°C, 10-60 min) conducted after application through discharge. Viscosity [is expressed as] measured values at 20°C.

**Table 19**

| Composition | Contact angle[°] | Viscosity [cps] | Surface tension [dyne/cm] | Discharge properties | Film-forming properties |
|---|---|---|---|---|---|
| 1 | 130 | 1.2 | 73.0 | X | - |
| 2 | 63 | 0.9 | 38.5 | X | - |
| 3 | 120 | 4.5 | 68.0 | ○ | Δ |
| 4 | 84 | 4.0 | 62.3 | ⊚ | ○ |
| 5 | 64 | 3.5 | 40.0 | ⊚ | ⊚ |

From the preceding results, it will be apparent that the concentration of the conductive high-molecular weight material is preferably 0.01 wt%-10.0 wt% based on the entire composition, and especially preferably 0.1 wt%-5.0 wt%. The reason is that if the conductive high-molecular weight material concentration is too low, a large number of discharges will be needed to produce the required film thickness, and mass-production efficiency will be poor, while on the other hand, if the conductive high-molecular weight material concentration is too high, viscosity will be higher.

In preferred practice, the composition for a hole injecting and transporting layer will contain a lubricant. This can effectively prevent drying and solidification of the ink composition in the ink-jet nozzle mouth. Examples of the lubricant are glycerin, diethylene glycol, and other polyhydric alcohols; glycerin is especially preferred. In preferred practice, the added amount of lubricant is equivalent to about 5 wt%-20 wt% based on the entire composition.

In preferred practice, water, a mixed solvent of water and a lower alcohol, or a mixed solvent of water and a Cellosolve solvent will be used as the polar solvent used for the composition for a hole injecting and transporting layer. The use of these solvents makes it possible to adjust the contact angle of the composition for a hole injecting and transporting layer with respect to the material of the nozzle face of the ink-jet head, the viscosity, and the surface tension without any loss of solubility or dispersibility of the conductive compound. Methanol or ethanol is preferred as the lower alcohol. From the standpoint of film-forming properties, ethoxy ethanol is preferred as the Cellosolve solvent.

Other additives, as well as film stabilizing materials, may be added as well; for example, viscosity modifiers, antioxidants, pH modifiers, preservatives, resin emulsions, leveling agents, etc., may be used.

### (Manufacturing process for composition for a hole injecting and transporting layer)

A comparison of film-forming properties and light emission characteristics with and without sonication and a filtration step was conducted using the composition for a hole injecting and transporting layer (Composition 15) given in Table 18, and is given in Table 7. PPV (poly(para-phenylene vinylene)) was used as a green light-emitting layer.

**Table 20**

| Step | | Film quality | luminance [cd/m²] | light emission initial voltage [V^{th}] | light emission lifetime [hr] |
|---|---|---|---|---|---|
| sonication step and filtration step | yes | ⊚ | 2000 | 3.0 | 5000 |
| | no | Δ | 1000 | 5.0 | 500 |

As will be apparent from the preceding results, conducting sonication increases the dispersion, and the use of a composition prepared by filtration of a sonicated dispersion affords a homogeneous hole injecting and transporting layer that has good flatness. In preferred practice, film thickness is 0.05 µm-0.1 µm. The reason is that the film-forming properties of the hole injecting and transporting layer affect the light emission characteristics of the element.

The manufacturing steps for the organic EL element of the present aspect of embodiment are the same as in Aspect of Embodiment 1.

### INDUSTRIAL APPLICABILITY

According to the present invention, a composition for a hole injecting and transporting layer is prepared as a liquid, thus permitting optimal design of materials, and the liquid composition is prepared as an ink, thus permitting high-precision patterning of a hole injecting and transporting layer by ink-jet system. Further, the use of a conductive compound, particularly a high-molecular weight material, as the hole injecting and transporting layer material affords manufacture of an organic EL element having high reliability and high qualities.

According to the ink-jet system patterning which pertains to the present invention, there is provided simple, low-cost hole injecting and transporting layer formation.

According to the manufacturing process for an organic EL element which pertains to the present invention, film thickness, number of dots, and other parameters can be adjusted in a desired manner, allowing the size and pattern of a light-emitting element to be established in a desired manner as well. Further, by combining light-emitting layers of the three primary colors (red, green, blue) produced through ink-jet system patterning, it is possible to develop a highly detailed full-color display with excellent light emission characteristics.

## Claims

1. A process of manufacturing an organic EL element including a hole injecting and transporting layer and a light-emitting layer, the method comprising:
forming a partitioning member having: openings corresponding to pixel areas on a substrate; and
forming the hole injecting and transporting layer by using an ink-jet type recording head to eject a composition including a conductive compound into the openings, the composition having a viscosity in the range 1 cps to 20 cps at a temperature of 20°C.

2. The method according to claim 1,
the compound having a lower ionization potential than an anode of the EL element.

3. The method according to claim 1 or claim 2,
the anode being ITO and the compound having a lower ionisation potential than an anode of the EL element.

4. The method according to any one of claims 1 to 3,
the compound being present in a dissolved or dispersed state in a polar solvent, and water being the principal solvent.

5. The method according to claim 4,
the polar solvent including methanol or ethanol.

6. The method according to claim 4,
the polar solvent being a mixed solvent of water and a Cellosolve solvent.

7. The method according to claim 6,
the Cellosolve solvent being ethoxy ethanol.

8. The method according to any one of the preceding claims,
the composition further comprising a lubricant.

9. The method according to claim 8,
the lubricant being glycerine.

## Patentansprüche

1. Verfahren zur Herstellung eines organischen EL-Elements, das eine Lochinjektions- und Transportierschicht und eine Licht emittierende Schicht enthält, wobei das Verfahren umfasst:
Bilden eines Trennelements mit Öffnungen, die Pixelflächen entsprechen, auf einem Substrat; und
Bilden der Lochinjektions- und Transportierschicht unter Verwendung eines Aufzeichnungskopfs vom Tintenstrahltyp zum Ausstoßen einer Zusammensetzung, die eine leitende Verbindung enthält, in die Öffnungen, wobei die Zusammensetzung eine Viskosität im Bereich von 1 cps bis 20 cps bei einer Temperatur von 20°C hat.

2. Verfahren nach Anspruch 1,
wobei die Verbindung ein geringeres Ionisierungspotenzial als eine Anode des EL-Elements hat.

3. Verfahren nach Anspruch 1 oder 2,
wobei die Anode ITO ist und die Verbindung ein geringeres Ionisierungspotenzial als eine Anode des EL-Elements hat.

4. Verfahren nach einem der Ansprüche 1 bis 3,
wobei die Verbindung in einem gelösten oder dispergierten Zustand in einem polaren Lösemittel vorliegt und Wasser das Hauptlösemittel ist.

5. Verfahren nach Anspruch 4,
wobei das polare Lösemittel Methanol oder Ethanol enthält.

6. Verfahren nach Anspruch 4,
wobei das polare Lösemittel ein gemischtes Lösemittel aus Wasser und einem Cellosolve-Lösemittel ist.

7. Verfahren nach Anspruch 6,
wobei das Cellosolve-Lösemittel Ethoxyethanol ist.

8. Verfahren nach einem der vorangehenden Ansprüche,
wobei die Zusammensetzung des Weiteren ein Schmiermittel umfasst.

9. Verfahren nach Anspruch 8,
wobei das Schmiermittel Glycerin ist.

## Revendications

1. Procédé de fabrication d'un élément électroluminescent organique comprenant une couche d'injection et de transport de trous et une couche d'émission de lumière, le procédé comprenant :
formation d'un élément de séparation ayant des ouvertures correspondant à des zones de pixels sur un substrat ; et
formation de la couche d'injection et de transport de trous en utilisant une tête d'impression de type à jet d'encre pour éjecter une composition comprenant un composé conducteur à l'intérieur des ouvertures, la composition ayant une viscosité dans la plage de 1 cps à 20 cps à une température de 20°C.

2. Procédé selon la revendication 1, le composé ayant un potentiel de ionisation inférieur à une anode de l'élément électroluminescent.

3. Procédé selon la revendication 1 ou la revendication 2,
l'anode étant de l'ITO et le composé ayant un potentiel de ionisation inférieur à une anode de l'élément électroluminescent.

4. Procédé selon l'une quelconque des revendications 1 à 3,
le composé étant présent dans un état de dissolution ou de dispersion dans un solvant polaire, et de l'eau étant le principal solvant.

5. Procédé selon la revendication 4, le solvant polaire comprenant du méthanol ou de l'éthanol.

6. Procédé selon la revendication 4, le solvant polaire étant un solvant mélangé à base d'eau et d'un solvant cellosolve.

7. Procédé selon la revendication 6, le solvant cellosolve étant de l'éthoxy éthanol.

8. Procédé selon l'une quelconque des revendications précédentes, la composition comprenant en outre un lubrifiant.

9. Procédé selon la revendication 8, le lubrifiant étant de la glycérine.
